# EUROPEAN PATENT APPLICATION

(11) **EP 1 783 911 A2**
(43) Date of publication of application: **09.05.2007**
(21) Application number: 06118289.5
(22) Date of filing: 02.08.2006
(51) Int. Cl.: H03K 19/003

(54) **Dual path redundancy with stacked transistor voting**

(30) Priority: 03.11.2005 US 266447
(71) Applicant: Honeywell International Inc., Morristown, New Jersey 07962 (US)
(72) Inventor: Friedman, Mark E., Eldersburg, MD 21784 (US)
(74) Representative: Haley, Stephen

(57) **Abstract**

A method of operation and an apparatus for radiation hardening a combinational logic circuit are presented. A section of logic that is to be radiation hardened is identified. An entire logic circuit or a portion of the logic circuit may be radiation hardened. Once the section of logic is identified, a Field Effect Transistor (FET) is duplicated so as to create a voter FET. The voter FET is coupled with an original node (or signal) and a duplicated node (or signal). If a radiation event strikes either the original node or the duplicated node, the voter FET will prevent an upset from propagatmg to down stream logic by preventing a conduction path through the voter FET. Additionally, all of the circuitry that was duplicated in order to create the duplicated node may also undergo a radiation event without causing an upset to propagate to downsneam logic.

## Description

The United States Government has acquired certain rights in this invention pursuant to Contract No. NASS-97263 awarded by NASA.

The present invention relates generally to a combinational logic voting scheme, and more particularly, a radiation hardened logic circuit with dual path redundancy.

In digital circuits and systems, a collection of logic gates that performs Boolean or logical functions on input signals to create output signals is commonly referred to as combinational logic. The basic building blocks of combinational logic are NOT, NOR, and NAND logic gates, Additionally logic gates such as OR, AND, and XOR logic gates may be constructed using these basic building blocks.

At a physical level the above logic gates comprise transistors. Complimentary paired transistors are configured in multiple types of configurations in order to create a specific logic gate. Because transistors are made of semiconductor materials that do not withstand ions transitioning through them, radiation events (e.g., particle strikes) may cause one or more transistors within a logic gate to become conductive and change state from "off" to "on", A radiation event, also referred to as a glitch, may initiate logical switching in a logic circuit which may result in two basic effects; a Single Event Transient (SET) or a Single Event Upset (SEU). Typically, within the duration of a glitch, a disturbed transistor will recover back to its off-state unless its control voltage level has been affected by the glitch.

The first effect, SET, by definition, is a glitch logically propagated from an affected node to a logic circuit output. If such a glitch causes a change in state of a memory circuit then this effect becomes the second type of effect: an SEU or soft error. SEU events, more so than SET events, may be detrimental to a logic circuit and circuits relying on the logic circuit. The wrong output signal at the data output of a memory circuit could cause circuits relying on the memory circuit to malfunction or be delayed.

One method of reducing radiation effects to, or radiation hardening, a logic circuit is to implement a majority voting scheme. A logic circuit may be replicated into at least three redundant circuits. An output from each redundant logic circuit is then fed to an AND type logic gate, for example. If a radiation event occurs, such as an SET, the AND gate is used to determine a correct output based on the "majority" of signal levels it receives. For example, if a radiation event occurs on one of the redundant circuits, one of the inputs the AND gate receives will be invalid. Because the other two outputs of the redundant circuits should have a correct output, however, the AND gate will continue to output a correct signal because the majority of its inputs are at a correct level.

Unfortunately, replicating entire logic circuits increases the amount of area a particular logic circuit may use. This produces several undesirable consequences. One consequence is that the amount of power a logic circuit consumes is increased. A second consequence is less room for other circuits within an integrated circuit. A third consequence is an increased cost of the integrated circuit. Therefore, a method and apparatus for preventing the propagation of SETs in the event of a radiation event is presented.

A method of operation and an apparatus for radiation hardening a combinational logic circuit are presented. An example radiation hardened logic circuit includes an original node, a duplicated node, and a series of stacked Field Effect Transistors (FETs). The stacked FETs are used to construct a voter FET. The voter FET receives two input signals. One input signal is received from the original node. The other input signal is received from the duplicated node. Both input signals may be used to create a conduction path in the voter FET. A conduction path, however may only be created when the first and second input signals are at an equivalent voltage level.

An example method illustrates radiation hardening a section of combinational logic using a voter FET. The radiation hardened section of logic outputs a radiation hardened signal on a radiation hardened node. Nodes within the section of logic upstream to the radiation hardened node may be struck by a radiation event, creating a Single Event Transient (SET). This SET will be stopped at the radiation hardened node and no Single Event Upset (SEU) will occur.

Other examples include various arrangements of the voter FETs. These arrangements are used to create radiation hardened NOT, NOR, and NAND gates. Any one of the radiation hardened gates may be included in a section of combinational logic to make an output of the section of logic radiation hardened.

These as well as other aspects and advantages will become apparent to those of ordinary skill in the art by reading the following detailed description, with reference, where appropriate, to the accompanying drawings. Further, it is understood that this summary is merely an example and is not intended to limit the scope of the claims.

In the drawings:

Certain examples are described below in conjunction with the appended drawing figures, wherein like reference numerals refer to like elements in the various figures, and wherein:
Fig. 1a is a circuit diagram of a NOT gate;
Fig. 1b is a circuit diagram of a NAND gate;
Fig. 1c is a circuit diagram of a NOR gate;
Fig. 2a is a block diagram of a method of radiation hardening a section of combination logic circuitry;
Fig. 2b is a logic diagram of a logic circuit that is to be radiation hardened;
Fig. 2c is a circuit diagram of non-radiation and radiation hardened NOT gates;
Fig. 2d is a logic diagram of a radiation hardened logic circuit;
Fig. 3a is a block diagram of a method of operating a voter Field Effect Transistor (FET);
Fig. 3b is another logic diagram of a radiation hardened logic circuit;
Fig. 3c is a circuit diagram of a voter FET allowing a conduction path;
Fig. 3d is a circuit diagram of a voter FET prohibiting a conduction path;
Fig. 4a is a circuit diagram of a radiation hardened NAND gate;
Fig. 4b is a circuit diagram of another radiation hardened NAND gate;
Fig. 5a is a circuit diagram of a radiation hardened NOR gate; and
Fig. 5b is a circuit diagram of another radiation hardened NOR gate.

Example radiation hardened combinational logic circuits and a method of operation are presented. The radiation hardened logic circuit comprises a voter Field Effect Transistor (FET) which prevents a change in output state by not allowing conduction from its source to drain in a radiation event. The voter FET includes an original FET and a duplicate FET. The gate of the original FET is biased by the original signal. The gate of the second FET is biased by a duplicated signal. The duplicated signal may be generated from a duplicate logic circuit. A variety of logic circuits and gates may be constructed with the voter FET and its methods of implementation.

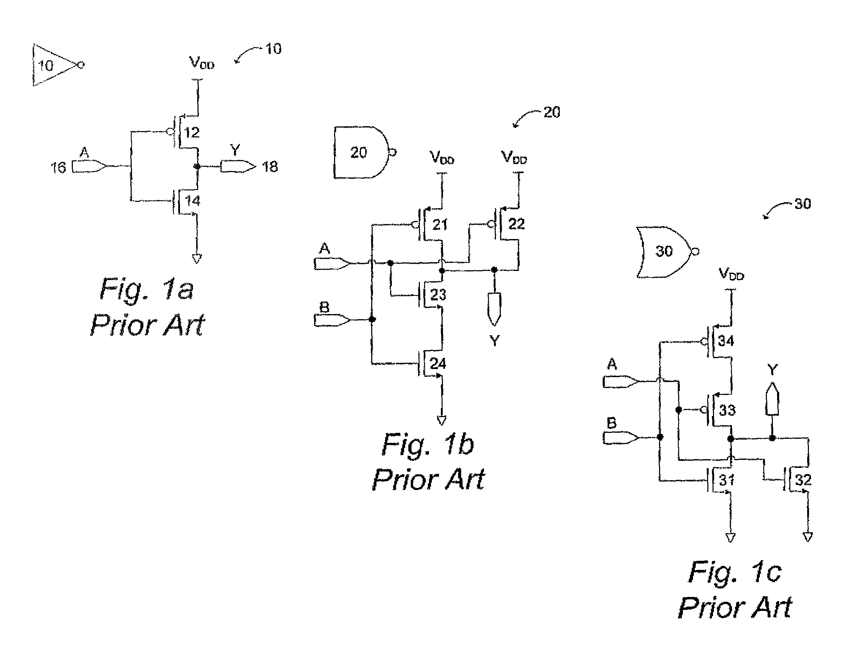

Turning now to Figs. 1a-c, example NOT 10, NAND 20, and NOR 30 logic gates are presented. Each logic gate includes an arrangement of FETs. In Fig. 1a, the NOT gate (inverter) 10 includes a p-type FET (pFET) 12 having its drain coupled to the drain of an n-type FET 14. The gates of FETs 12 and 14 are coupled to receive an input at input 16. An output 18 is taken from the drains of FET 14 and FET 12. When an input voltage signal at input 16 is "high", FET 14 will create a conduction path between its source and drain and will create a voltage signal at output 18 having a "low" level. Alternatively, when the input signal is "low", FET 14 will be closed (i.e., no conduction path between its source and drain) and FET 12 will open a conduction path between its source and drain. Output 18 will output a voltage signal having a "high" level. A truth table demonstrating the output for a particular input of NOT gate 10 is demonstrated in Table 1.

**Table 1 - NOT gate 10**

| A | Y |
|---|---|
| 1 | 0 |
| 0 | 1 |

where "1" represents a "high" voltage, "0" represents a "low" voltage, A is the input signal, and Y is the output signal.

When a radiation event, such as a Single Event Transient (SET) occurs, however, NOT gate 10 may not yield a correct output signal. The SET may propagate from upstream logic and be received at input 16 or it may occur internal to NOT gate 10. For example, initially, NOT gate 10 may have a "low" output signal at output 18. A particle strike in the channel region under the gate of FET 12, however, may cause FET 12 to inadvertently become conductive. This would cause NOT gate 10 to pull the signal at output 18 "high". On the other hand, if output 18 is initially "high", a particle strike at FET 14 may cause an opposite shift in the output signal at output 18 to a "low".

A radiation event, such as a particle strike, may also cause an error in the output of NAND gate 20 and NOR gate 30. NAND gate 20, which comprises FETs 21-24, may produce an erroneous output if a radiation event causes any one of FETs 21-24 to inadvertatly conduct. Likewise, NOR gate 30, which comprises FETs 31-34, is also vulnerable to radiation induced conduction of FETs 31-34. Truth tables demonstrating the output for given inputs of NAND gate 20 and NOR gate 30 are shown in Table 2 and Table 3 respectively.

**Table 2 - NAND gate 20**

| A | B | Y |
|---|---|---|
| 0 | 0 | 1 |
| 1 | 0 | 1 |
| 0 | 1 | 1 |
| 1 | 1 | 0 |

**Table 2 - NOR gate 30**

| A | B | Y |
|---|---|---|
| 0 | 0 | 1 |
| 1 | 0 | 0 |
| 0 | 1 | 0 |
| 1 | 1 | 0 |

where "1" represents a "high" voltage, "0" represents a "low" voltage, A and B are input signals, and Y is an output signal.

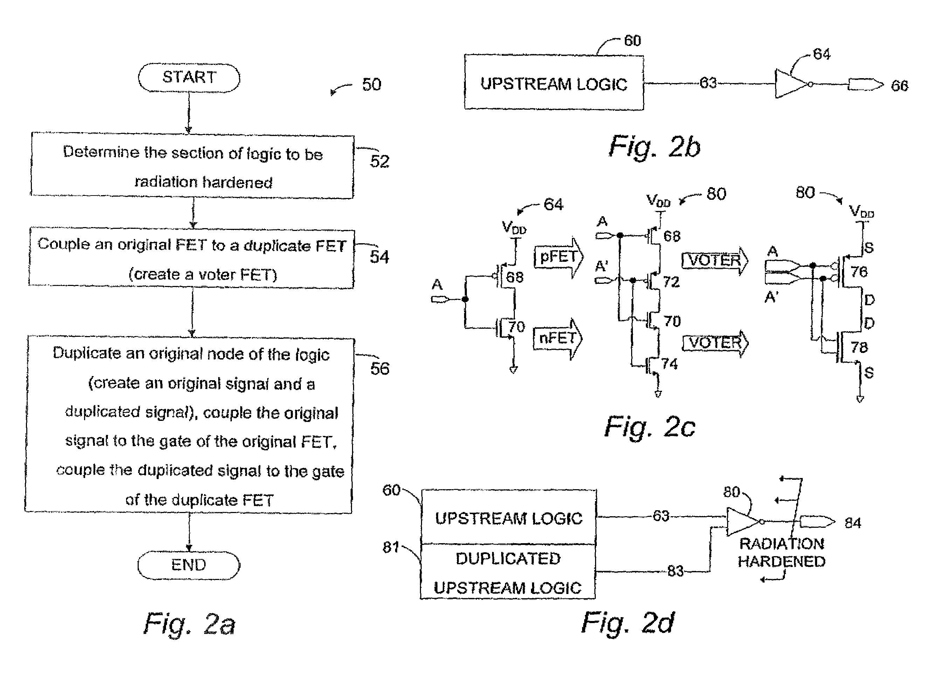

In order to prevent radiation hardened events from causing an upset, a method 50 for radiation hardening a section of combinational logic is presented in the block diagram of Fig. 2a. The first step, as shown at block 52, is to determine the section of combinational logic to be radiation hardened. This includes selecting a node, within the logic circuit, where the nodes upstream to the selected node, including the selected node, are to be radiation hardened. For example, Fig. 2b shows a section of combinational logic that includes upstream combinational logic 60 and a NOT gate 64. The output, or selected node 66 is to be radiation hardened.

The next step, as shown at block 54, is to couple an original FET to a duplicate FET. NOT gate 64, as shown in Fig. 2c, includes two FETs: an original pFET 68 coupled to an original nFET 70. By implementing the step at block 54, a duplicate pFET 72 is coupled to pFET 68 (via a source drain coupling). Additionally, a duplicate nFET 74 is coupled to nFET 70 (via a source drain coupling). Both pFETs 68 and 72 and nFETs 70 and 74 form dual-input voter FETs 76 and 78. Each voter FET 76, 78 has a source and a drain. Voter FET 76 has the source of pFET 68 as its source and the drain of pFET 72 as its drain. Voter FET 78 has the drain of nFET 70 as its drain and the source of nFET 74 as its source.

In operation, voter FETs 76 and 78 will only allow a conduction path from their source to drain when both of its inputs are equivalent. Voter FET 76, for example, will only allow a conduction path from its source to drain when the voltage at the gates of pFET 68 and pFET 72 is "low". Voter 78, on the other hand, will only allow a conduction path from its source to drain when the voltage at the gates of nFET 70 and 74 is "high".

After completion of the step shown at block 54, a radiation hardened NOT gate 80 is constructed from voter FETs 76 and 78. In contrast to NOT gate 64, radiation hardened NOT gate 80 has two inputs. One input is the orignal input supplied to pFET 68 and nFET 70. The other input is a duplicated input supplied to pFET 72 and nFET 74.

At the last step of method 50, shown at block 56, an original node is duplicated. Fig. 2d illustrated duplication of an original node 63. Upstream logic 60 is duplicated to created duplicated upstream logic 81. Output from upstream logic 60 is a duplicated signal on signal line (node) 83. Radiation hardened node 84 is output as a result of the method 50.

In the above examples, only one duplicate or redundant circuit may be used to create a radiation hardened circuit or node. Therefore, in contrast to a majority voting scheme (i.e., triple redundancy), the method 50 provides a reduced area, radiation hardened configuration. This promotes improved area optimization, reduced power consumption, and reduced cost.

The radiation hardened NOT gate 80, as presented in Fig. 2c, may have the truth table shown in Table 4.

**Table 4 - Radiation hardened NOT gate 80**

| A | A' | Y |
|---|---|---|
| 0 | 0 | 1 |
| 1 | 0 | float |
| 0 | 1 | float |
| 1 | 1 | 0 |

where "1" represents a "high" voltage, "0" represents a "low" voltage, A is an orignal input signal, A' is a duplicated input signal, and Y is an output signal. When a radiation event occurs causing signal A and A' to have a different level, output signal Y will float. The capacitance on node Y will maintain the voltage at a level that the output signal Y had prior to the radiation event occuring. The SET produced by a radiation event in one of the duplicated upstream logic sections is stopped by the voter FET.

A radiation event on one of the transistors of the voter FET itself will not change the signal Y level. For the case where signal Y is "high", a particle hit on either off transistor 70 or 74 will not cause an inadvertant conduction path because the other transistor (70 or 74) will still be off and signal Y will stay "high". For the case where signal Y is "low" the off transistors 68 and 72 are the vulnerable ones but one or the other will stay off and signal Y will stay "low". It is important to note that radiation events, such as SETs, are generally random. The probablity of a radiaton event occuring on two nodes in close proximity is very low. FETs in close proximity, however, may be affected by a single radiation event. The proximity of stacked FETs, such as pFETs 68 and 72 and nFETs 70 and 74, within respective voter FETs 76 and 78 should be considered so that a single radiation event does not cause an upset.

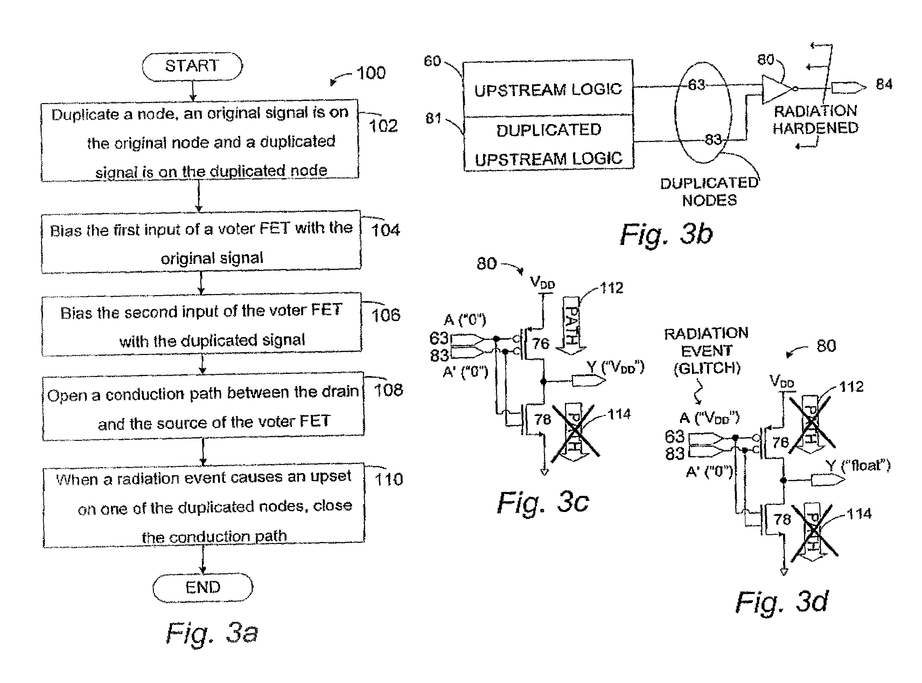

A radiation hardened logic gate, such as NOT gate 80, implementing a voter FET is radiation hardened because the voter FET closes its conduction path when a radiation event occurs. A method 100, illustrating operation of a voter FET is presented in Fig. 3a. Method 100 may be used to prevent an upstream radiation event (e.g., SET) from propagating downstream. At the first step, shown at block 102, the original signal is duplicated at a duplicated node. This is demonstrated in Fig. 3b. The signal on signal line 63 (original node) is duplicated on signal line 83 (duplicated node). At blocks 104 and 106, the first input of the voter FET is biased with the orignal signal and the second input of the voter FET is biased with the duplicated signal.

Fig. 3c illustrates the steps at block 104 and 106 of method 100 for the case with output signal Y at a "high". The first input of voter FETs 76 and 78 are biased at a "low" voltage. The second inputs of voter FETs 76 and 78 are also biased at a "low" voltage. At block 108 of method 100, a conduction path 112 is opened in voter FET 76. The output of radiation hardened NOT gate 80 is pulled "high". Note that a conduction path 114 is not opened in voter FET 78 because it is constructed from nFETs 70 and 74, which do not conduct at "low" gate voltages. The method 100 may also be applied to create the conduction path 114 through voter FET 78 by biasing the first and second inputs at "high" voltages for the signal Y at "low" case. The respective applied voltages for voter FET 76 and 78 should be large enough in magnitude to turn pFETs 68 and 72 or nFET5 70 and 74 "on". That is, the gate-source bias of each FET should have a magnitude greater than or equal to the turn on voltage of the FET that is to have a conduction path.

The next step of method 100, shown at block 110, is to close the conduction path when a radiation event occurs. For example, in Fig. 3d, a particle strike causes the "low" voltage on signal line 63 to glitch to a "high" voltage. When this happens, voter FET 76 closes its conduction path because signals lines (nodes) 63 and 83 are not in agreement Internal to voter FET 76, pFET 68 receives a "high" gate voltage and it is turned off. Although this also turns nFET 70 on, nFET 74 keeps the FET 78 conduction path closed. When there is no available conduction path to its output, the radiation hardened NOT gate 80 will float until the signal on signal line 63 recovers. When the signal on signal line 63 recovers, a conduction path may be reopened in voter FET 76.

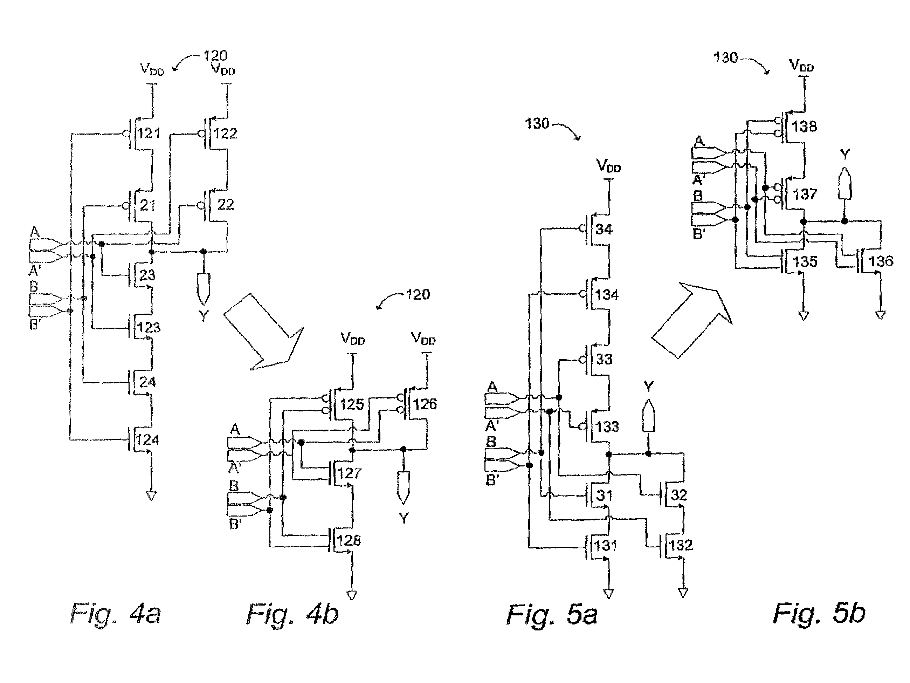

A variety of radiation hardened nodes and logic gates may be created by implementing a dual input voter FET. Fig. 4a is a circuit diagram of radiation hardened NAND gate 120 created from NAND gate 20 (illustrated in Fig. 1b). Method 50 is applied to construct duplicated FETs 121-124. Orignal FETs 21-24 and duplicated FETs 121-124 form the stacked transistors that voter FETs 125-128 comprise, as is illustrated in Fig. 4b.

Fig. 5a is a circuit diagram of radiation hardened NOR gate 130 created from NAND gate 30. Method 50 may also be applied to create the radiation hardened NOR gate 130 from NOR gate 30 (illustrated in Fig. 1c). Voters FETs 135-136, illustrated in Fig. 5b, comprise stacked FETs 31-34 and 131-134.

Tables 5 and 6 demonstrate respective truth tables for the radiation hardened NAND gate 120 and NOR gate 130.

**Table 5 - Radiation hardened NAND gate 120**

| A | A' | B | B' | Y |
|---|---|---|---|---|
| 0 | 0 | 0 | 0 | 1 |
| 0 | 0 | 1 | 1 | 1 |
| 1 | 1 | 0 | 0 | 1 |
| 1 | 1 | 1 | 1 | 0 |
| 0 | 0 | 0 | 1 | 1 |
| 0 | 0 | 1 | 0 | 1 |
| 0 | 1 | 0 | 0 | 1 |
| 1 | 0 | 0 | 0 | 1 |
| 1 | 1 | 1 | 0 | float |
| 1 | 1 | 0 | 1 | float |
| 1 | 0 | 1 | 1 | float |
| 0 | 1 | 1 | 1 | float |

**Table 6 - Radiation hardened NOR gate 130**

| A | A' | B | B' | Y |
|---|---|---|---|---|
| 0 | 0 | 0 | 0 | 1 |
| 0 | 0 | 1 | 1 | 0 |
| 1 | 1 | 0 | 0 | 0 |
| 1 | 1 | 1 | 1 | 0 |
| 0 | 0 | 0 | 1 | float |
| 0 | 0 | 1 | 0 | float |
| 0 | 1 | 0 | 0 | float |
| 1 | 0 | 0 | 0 | float |
| 1 | 1 | 1 | 0 | 0 |
| 1 | 1 | 0 | 1 | 0 |
| 1 | 0 | 1 | 1 | 0 |
| 0 | 1 | 1 | 1 | 0 |

where "1" represents a "high" voltage, "0" represents a "low" voltage, A and B are orignal input signals, A' and B' are duplicated input signals, and Y is an output signal. When a radiation event occurs in the NAND gate, leaving one and only one of the signals A, A', B, or B' "high", output signal Y will float. Capacitance will maintain the level that the output signal Y had prior to the radiation event occuring. For the NOR gate the float condition is caused by one and only one of the signals A, A', B, or B being "low" after a radiation event. For either the NAND gate or the NOR gate the correct output signal Y will be retained if a correct conduction path remains open after a radiation event. For example, in Fig. 4b all four input signals (i.e., A, A', B, B') may be "low". If a radiation event causes a glitch in signal A, causing it to go "high", voter FET 126 will dose its conduction path. Voter FET 125, however, will retain an open conduction path so that output signal Y will remain "high".

It should also to be noted that the above-described methods and apparatus may be embodied as software code, for example on a carrier medium such as a disk, CD-or DVD-ROM, programmed memory such as read only memory (Firmware), or on a data carrier such as an optical or electrical signal carrier. Thus the code may comprise conventional program code or microcode or, for example, code for setting up or controlling an ASIC or FPGA. The code may also comprise code for dynamically configuring re-configurable apparatus such as re-programmable logic gate arrays. Similarly the code may comprise code for a hardware description language such as Verilog or VHDL (Very high speed integrated circuit Hardware Description Language). As the skilled person will appreciate, the code may be distributed between a plurality of coupled components in communication with one another. Where appropriate, the above examples may also be implemented using code running on a field-(re-)programmable analog array or similar device in order to configure analog hardware.

The above examples describe radiation hardening a section of combinational logic by implementing a voter FET. The voter FET prevents inadvertent conduction during a radiation event. The voter FET and its methods of implementation may be used to construct a plurality of radiation hardened logic circuits and gates. It should be understood that the illustrated examples are examples only and should not be taken as limiting the scope of the present invention. The claims should not be read as limited to the described order or elements unless stated to that effect Therefore, all examples that come within the scope and spirit of the following claims and equivalents thereto are claimed as the invention.

## Claims

1. A radiation hardened logic gate, the logic gate comprising:
first and second p-type Field Effect Transistors (pFETs) each having a gate, a source, and a drain, the drain of the first pFET coupled to the source of the second pFET so as to create a first voter pFET, the source of the first pFET being the source of the first voter pFET, the drain of the second pFET being the drain of the first voter pFET, and the gates of the first and second pFETs being respective first and second inputs of the first voter pFET; and
first and second n-type Field Effect Transistor (nFETs) each having a gate, a scarce, and a drain, the drain of the first nFET coupled to the source of the second nFET so as to create a first voter nFET, the source of the first nFET being the source of the first voter nFET, the drain of the second nFET being the drain of the first voter nFET, the gates of the first and second nFETs being respective first and second inputs of the first voter nFET, and the drain of the first voter nFET coupled to the drain of the second voter pFET.

2. The logic gate as in claim 1, wherein the first inputs of the first voter nFET and pFET are coupled to receive a first input signal, the second inputs of the first voter nFET and pFET are coupled to receive a second input signal, and the drain of the first voter nFET being an output of the logic gate thereby allowing the logic gate, in operation, to perform a logical NOT operation.

3. The logic gate as in claim 2, wherein the first and second input signals are duplicated signals, the logic gate performing the logical NOT operation when the first and second input signals are equivalent.

4. The logic gate as in claim 1, further comprising:
third and fourth pFETs each having a gate, a source, and a drain, the drain of the third pFET coupled to the source of the fourth pFET so as to create a second voter pFET, the source of the third pFET being the source of the second voter pFET, the drain of the fourth pFET being the drain of the second voter pFET, the gates of the third and fourth pFETs being respective first and second inputs of the second voter pFET, and the drain of the second voter pFET coupled to the source of the first voter pFET; and
third and fourth nFETs each having a gate, a source, and a drain, the drain of the third nFET coupled to the source of the fourth nFET so as to create a second voter nFET, the source of the third nFET being the source of the second voter nFET, the drain of the fourth nFET being the drain of the second voter nFET, the gates of the third and fourth nFETs being respective first and second inputs of the second voter nFET, and the drain of the second voter nFET coupled to the drain of the first voter nFET.

5. The logic gate as in claim 4, wherein the first inputs of the first voter nFET and pFET are coupled to receive a first input signal, the second inputs of the first voter nFET and pFET are coupled to receive a second input signal, the first inputs of the second voter nFET and pFET are coupled to receive a third input signal, the second inputs of the second voter nFET and pFET are coupled to receive a fourth input signal, and the drain of the first voter nFET being an output of the logic gate thereby allowing the logic gate, in operation, to perform a logical NOR operation.

6. The logic gate as in claim 5, wherein first and second input signals are first duplicated signals, the third and fourth input signals are second duplicated signals, the logic gate performing the logical NOR operation when the first and second input signals are equivalent and the third and fourth input signals are equivalent.

7. The logic gate as in claim 1, further comprising:
third and fourth pFETs each having a gate, a source, and a drain, the drain of the third pFET coupled to the source of the fourth pFET so as to create a second voter pFET, the source of the third pFET being the source of the second voter pFET, the drain of the fourth pFET being the drain of the second voter pFET, the gates of the third and fourth pFETs being respective first and second inputs of the second voter pFET, and the drain of the second voter pFET coupled to the drain of the first voter pFET; and
third and fourth nFETs each having a gate, a source, and a drain, the drain of the third nFET coupled to the source of the fourth nFET so as to create a second voter nFET, the source of the third nFET being the source of the second voter nFET, the drain of the fourth nFET being the drain of the second voter nFET, the gates of the third and fourth nFETs being respective first and second inputs of the second voter nFET, and the source of the second voter nFET coupled to the drain of the first voter nFET.

8. The logic gate as in claim 7, wherein the first inputs of the first voter nFET and pFET are coupled to receive a first input signal, the second inputs of the first voter nFET and pFET are coupled to receive a second input signal, the first inputs of the second voter nFET and pFET are coupled to receive a third input signal, the second inputs of the second voter nFET and pFET are coupled to receive a fourth input signal, and the drain of the first voter nFET being an output of the logic gate thereby allowing the logic gate, in operation, to perform a logical NAND operation.

9. The logic gate as in claim 8, wherein first and second input signals and the third and fourth input signals are duplicated signals, the logic gate performing the logical NAND operation when the first and second input signals are equivalent and the third and fourth input signals are equivalent.
